# EUROPÄISCHE PATENTSCHRIFT

(11) **EP 1 231 714 B1**
(45) Veröffentlichungstag und Bekanntmachung des Hinweises auf die Patenterteilung: **18.05.2005**
(21) Anmeldenummer: 02001439.5
(22) Anmeldetag: 21.01.2002
(51) Int. Cl.: H03J 3/24, H04B 1/10

(54) **Fernsehempfänger**
Television receiver
Récepteur de télévision

(30) Priorität: 09.02.2001 DE 10106071
(43) Veröffentlichungstag der Anmeldung: 14.08.2002
(73) Patentinhaber: Harman/Becker Automotive Systems GmbH, 76307 Karlsbad (DE)
(72) Erfinder: Zahm, Michael, 76337 Waldbronn (DE); Geiger, Erich, 75236 Kämpfelbach (DE)
(74) Vertreter: Schmuckermaier, Bernhard

(56) Entgegenhaltungen:
- EP-A- 0 455 974
- GB-A- 2 059 223
- US-A- 5 095 534

## Beschreibung

Die Erfindung betrifft einen Fernsehempfänger mit einer Kanalwählerstufe (2), einer dieser nachgeschalteten selektiven Filterstufe (3) und einer dieser nachgeschalteten Zwischenfrequenzstufe (4),dadurch gekennzeichnet, dass wobei eine Feldstärkedetektionsstufe (9, 4) vorgesehen ist, die ein der Feldstärke des Empfangssignals (HF) proportionales Feldstärkesignal erzeugt, und
die selektive Filterstufe (3) eine Übertragungsfunktion aufweist, die mittels eines Steuersignals (CS, TS) veränderbar ist.

Ein derartiger Fernsehempfänger ist beispielsweise aus der GB 2 059 223 bekannt. Aus der US 5 059 534 geht ein ähnlicher Fernsehempfänger hervor.
Im Gegensatz zu stationären Fernsehempfängern sind bei mobilen Fernsehempfängern ständig wechselnde Empfangsverhältnisse gegeben. Beispielsweise bei Einbau des mobilen Fernsehempfängers in ein Fahrzeug ändert sich mit der Position des Fahrzeugs zwangsläufig auch die Position der Antennen. Während die Antenne des stationären Fernsehempfängers einmal optimal ausgerichtet und dann fixiert wird, lässt sich beim mobilen Fernsehempfänger nicht vermeiden, dass das Fahrzeug und damit auch die daran befindlichen Antennen sich in Positionen befinden, die nur mässigen oder sogar schlechten Empfang bieten. Daher ist bei der Entwicklung von mobilen Fernsehempfängern besonderes Augenmerk auf das Verhalten des Fernsehempfängers bei niedrigen Empfangspegeln zu legen.

Ein niedriger Empfangspegel bedeutet einen hohen Rauschanteil im Nutzsignal. Die Folgen des geringen Signal-/Rauschabstandes äussern sich subjektiv als kaum erkennbares Bild, Verlust der Horizontal- und Vertikalsynchronisation, Einsetzen der Farbunterdrückung oder sogar als vollständiger Bildverlust. Dieses Verhalten wird im wesentlichen verursacht durch das Ausrasten von Phasenregelkreisen (PLL) zur Videosignalverarbeitung, durch unstetige Synchronimpulsseparierung, durch gestörte Verstärkungsregelungen (AGC) und durch fehlerhafte Farbträgerrückgewinnung. Rastet beispielsweise bereits bei der Umsetzung der Zwischenfrequenz in das Basisband der Frequenz-Phasen-Regelkreis (FPLL) des Synchrondemodulators aus, bedeutet dies einen kompletten Bildverlust und eine erhebliche Totzeit für das Gesamtsystem, da jeder Phasenregelkreis eine gewisse Zeit bis zum Erreichen eines neuen Einrastzustandes benötigt. Eine Senkung der Funktionsgrenze um 3 bis 6 dB bedeutet in der Praxis eine erhebliche Steigerung der Darbietungsqualität des mobilen Fernsehempfängers und stellt ein bedeutendes Qualitätskriterium dar.

Soll darüber hinaus das empfangene Bildsignal zur weiteren digitalen Übertragung in Multimediasystemen verwendet werden, wird zur Reduzierung der Übertragungsbandbreite in der Regel ein Komprimierungsverfahren (z.B. MPEG) eingesetzt. Die bei solchen Komprimierungsverfahren eingesetzten Algorithmen reduzieren die Informationen unter anderem in Abhängigkeit vom Bildinhalt und von dessen Änderungen. Bildinhalte mit gleichmäßigem Verlauf benötigen daher eine geringere Bitrate zur Übertragung, detailreiche Bildinhalte eine höhere. Rauschanteile im Bildsignal werden allerdings vom Kompressionsalgorithmus als detailreiche Bildveränderungen interpretiert. Dies hat dann wiederum den Nachteil, dass die Bitrate stark ansteigt und/oder unerwünschte Nebeneffekte auftreten.

Aufgabe der Erfindung ist es daher, einen Fernsehempfänger der eingangs genannten Art im Hinblick auf die Anforderungen für einen mobilen Einsatz zu verbessern.

Die Aufgabe wird gelöst durch einen Fernsehempfänger gemäß Patentanspruch 1. Ausgestaltungen und Weiterbildungen des Erfindungsgedankens sind Gegenstand von Unteransprüchen.

Vorteil der Erfindung ist es, dass bereits mit geringem Mehraufwand eine deutliche Verbesserung des Verhaltens bei mobilem Einsatz erzielt wird.

Erreicht wird dies im einzelnen dadurch, dass eine Feldstärkedetektionsstufe vorgesehen wird, die ein der Feldstärke des Empfangssignals proportionales Feldstärkesignal erzeugt. Dabei weist die eingangs genannte selektive Filterstufe eine Übertragungsfunktion auf, die mittels eines Steuersignals veränderbar ist, wobei das Steuersignal aus dem Feldstärkesignal hergeleitet wird.

Insbesondere ist vorgesehen, dass abhängig vom Steuersignal die Bandbreite der selektiven Filterstufe verändert wird. Durch Reduzierung der Bandbreite werden Rauschanteile unterdrückt oder vermindert, während die für das Nutzsignal wichtigen Spektralanteile im Durchlassbereich des Filters liegen. Vorzugsweise kommen Tiefpassfilter, Bandpassfilter und Bandsperren zum Einsatz, deren Durchlassbereich oder Sperrbereich dementsprechend verringert wird. Damit wird erreicht, dass beispielsweise schon bei der Demodulation der Zwischenfrequenzsignale der Frequenz-Phasen-Regelkreis des Synchrondemodulators länger eingerastet bleibt.

Weiterhin kann mindestens eine weitere selektive Filterstufe der Zwischenfrequenzstufe nachgeschaltet sein, die durch ein ebenfalls aus dem Feldstärkesignal hergeleitetes Steuersignal gesteuert wird. Zusätzliche, gesteuerte Filterstufen können sich dabei auch nach der Demodulation, also nach der Zwischenfrequenzstufe befinden und beispielsweise Bildsignale (FBAS-Signale) so formen, dass nachfolgende signalverarbeitende Stufen längere Funktionen aufrechterhalten können. Bei sämtlichen Filterstufen können als geeignete Filtertypen Tiefpässe, Bandpässe und in der Zwischenfrequenzebene auch Hochpässe Verwendung finden. In besonderen Fällen wirken auch Kerbfilter vorteilhaft.

In der Zwischenfrequenzebene vor dem Demodulator wird bevorzugt eine Frequenzfalle vorgesehen, deren Steilheit durch das Steuersignal veränderbar ist. Diese ist so dimensioniert, dass bei stärkerem Einsatz Spektralanteile des Chrominanzsignals stärker unterdrückt werden, bei schwachem Einsatz aber Rauschanteile im Spektralbereich von Luminanz- und Chrominanzsignal abgesenkt werden. Die Auslegung der Filterkurven erfolgt im Abhängigkeit von den Erfordernissen der nachgeschalteten Funktionsstufen, wobei aber auch insbesondere subjektive Faktoren berücksichtigt werden. Beispielsweise wird es bei sehr schwachem Signal vom Betrachter oft als wenig störend empfunden, wenn nur die Schwarz-Weiß-Anteile des Bildes gezeigt werden. Synchronisationsverlust oder Standbild dagegen stören den Betrachter weit aus mehr. Darüber hinaus bewirkt eine Reduzierung von höherfrequenten Bildanteilen einen Art Weichzeichnereffekt, der bei schlechtem Empfangsignal ebenfalls einen angenehmeren Bildeindruck erzeugt. Demgemäss werden bei einer Weiterbildung der Erfindung im Empfangssignal enthaltene Schwarz-Weiß-Signale bei niedrigem Feldstärkesignal durch das bzw. die selektiven Filterstufen allein durchgelassen. Zusätzlich oder alternativ können auch bei niedrigem Feldstärkesignal im Empfangsignal enthaltene höherfrequente Bildsignale durch das bzw. die selektiven Filterstufen unterdrückt werden.

Der Verlauf der Übertragungsfunktionen der einzelnen selektiven Filterstufen ist abhängig von einem Steuersignal. Grundsätzlich können dabei die Filterstufen so gesteuert werden, dass bei einem akzeptablen Empfangssignal keine Beeinflussung des Nutzsignals erfolgt, bei schlechter werdenden Empfangssignal sich die selektiven Filterstufen stetig oder in Abstufungen an die Empfangsverhältnisse adaptieren. Auf diese Weise wird eine erhebliche Empfangsverbesserung erzielt.

Die Feldstärkeinformation wird durch eine spezielle Einrichtung, die Feldstärkedetektionsstufe, gewonnen, die entweder vor der Kanalwählerstufe oder nach der Kanalwählerstufe das Empfangssignal detektiert. Außerdem kann die Feldstärkinformation auch aus der Regelspannung der Zwischenfrequenzstufe hergeleitet werden. Es wird also in allen drei Fällen ein der Feldstärke proportionales Steuersignal erzeugt.

Bei einer weiteren Ausgestaltung der Erfindung wird das Steuersignal neben dem Feldstärkesignal noch auch aus mindestens einem weiteren Signal mindestens einer weiteren Signalverarbeitungsstufe, die der Zwischenfrequenzstufe nachfolgt, hergeleitet. Solche Signale werden beispielsweise aus Informationen über Synchronisationsverlust, Rauschanteilen im Bild, Anstieg oder nicht ausreichende Bitrate abgeleitet. Diese Informationen können die selektiven Filterstufen in unterschiedlicher Weise beeinflussen wie beispielsweise hinsichtlich der Ansprechzeit oder der Übertragungsfunktion der Filterstufen.

Insgesamt können sämtliche Funktionen insbesondere die Funktionen der selektiven Filterstufen digital realisiert werden.

Die Erfindung wird nachfolgend anhand der in den Figuren der Zeichnung dargestellten Ausführungsbeispiele näher erläutert. Es zeigt:
- Figur 1:: ein erstes Ausführungsbeispiel eines erfindungsgemäßen Fernsehempfängers mit einer steuerbaren selektiven Filterstufe,
- Figur 2:: ein zweites Ausführungsbeispiel eines erfindungsgemäßen Fernsehempfängers mit zwei steuerbaren selektiven Filterstufen und
- Figur 3:: ein drittes Ausführungsbeispiel eines erfindungsgemäßen Fernsehempfängers mit zwei steuerbaren selektiven Filterstufen und erweitertem Steuersignal.

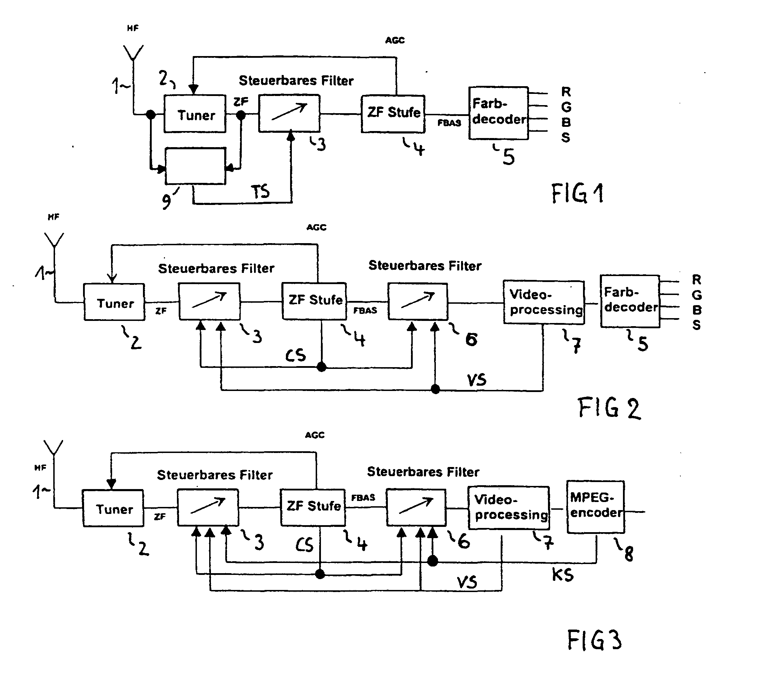

Bei dem in Figur 1 gezeigten Ausführungsbeispiel wird ein Hochfrequenzsignal HF von einer Antenne 1 aufgenommen und an eine Kanalwählerstufe (Tuner) 2 weitergegeben. Die Empfindlichkeit der Kanalwählerstufe 2 wird dabei durch ein Verstärkungssteuersignal AGC bestimmt. Die Kanalwählerstufe 2 erzeugt aus dem von der Antenne 1 gelieferten Hochfrequenzsignal HF beispielsweise durch Mischen mit einem Trägersignal ein Zwischenfrequenzsignal ZF.

Das Zwischenfrequenzsignal ZF wird unter Zwischenschaltung einer selektiven Filterstufe 3 einer Zwischenfrequenzstufe 4 zugeführt, die daraus ein Farbsignal FBAS erzeugt. Das selektive Filter ist dabei durch ein Steuersignal TS in seiner Übertragungsfunktion veränderbar. Sowohl das Steuersignal AGC als auch das Steuersignal TS werden dabei aus einem in einer Feldstärkedetektionsstufe 9 erzeugten Feldstärkesignal abgeleitet. Die Feldstärkedetektionsstufe 9 erzeugt beim Ausführungsbeispiel das Feldstärkesignal aus dem Eingangs- und/oder Ausgangssignal der Kanalwählerstufe 2. Beispielsweise kann das Feldstärkesignal gleich dem Steuersignal TS sein. Der Zwischenfrequenzstufe 4 ist schließlich ein Farbdecoder 5 nachgeschaltet, der aus dem Bildsignal FBAS vier Farbsignale R, G, B und S erzeugt.

Das Ausführungsbeispiel nach Figur 2 ist gegenüber Figur 1 dahingehend abgeändert, dass die selektive Filterstufe 3 durch zwei andere Steuersignale, nämlich den Steuersignalen VS und CS, gesteuert wird. Darüber hinaus ist zwischen die Zwischenfrequenzstufe 4 und dem Farbdecoder 5 eine weitere selektive Filterstufe 6 sowie eine dieser nachfolgende Videobearbeitungsstufe 7 dazwischengeschaltet. Die selektive Filterstufe 6 ist dabei ebenfalls zumindest in einzelnen Punkten der Übertragungsfunktion veränderbar. Die Steuerung der weiteren selektiven Filterstufe 6 erfolgt zum einen durch das Steuersignal CS und zum anderen durch das Steuersignal VS. Das Steuersignal VS wird dabei von der Bildsignalbearbeitungseinrichtung 7 erzeugt, während das Steuersignal CS von der Zwischenfrequenzstufe 4 bereitgestellt wird. Das Steuersignal CS wird also nicht aus Feldstärkeinformationen, die in der Kanalwählerstufe 2 vorliegen, sondern aus solchen die in der Zwischenfrequenzstufe 4 vorliegen, abgeleitet. Das Steuersignal VS geht aus Signalen hervor, welche die Bildgüte qualifizieren.

Das Ausführungsbeispiel nach Figur 3 geht aus dem in Figur 2 gezeigten Ausführungsbeispiel dadurch hervor, dass anstelle des Farbdecoders 5 eine Bilddatenkomprimierungsstufe 8 vorgesehen ist. Darüber hinaus wird die selektive Filterstufe 3 nicht durch das Steuersignal TS von der Kanalwählerstufe 2 wie in Figur 1 gesteuert, sondern durch ein Steuersignal KS, welches von der Bilddatenkomprimierungsstufe 8 bereitgestellt wird und das wiederum aus Informationen über die aktuelle Bildgüte abgeleitet wird.

Bei den in den Figuren gezeigten Ausführungsbeispielen können als selektive Filterstufen Tiefpässe oder Bandpässe verwendet werden, in der Zwischenfrequenzebene auch Hochpässe. Darüber hinaus werden bei bestimmten Anwendungen auch Kerbfilter bzw. Frequenzfallen bevorzugt eingesetzt. Insbesondere hat sich vor dem Demodulator der Einsatz einer versteilerteen Falle bewährt. Diese ist so ausgelegt, dass bei stärkerem Einsatz Spektralanteile des Chrominanzsignals stärker unterdrückt werden, bei schwachem Einsatz aber Rauschanteile im Spektralbereich von Luminanz und Chrominanz abgesenkt werden. Bei den selektiven Filterstufen können demnach die Lage des Durchlassbereiches bzw. Sperrbereiches, dessen Breite und Steilheit durch die jeweiligen Steuersignale CS, TS und KS verändert werden. So werden beispielsweise durch die Reduzierung der Bandbreite Rauschanteile unterdrückt oder vermindert, wobei die für das Nutzsignal wichtigen Spektralanteile beispielsweise durch Verändern der Lage des Durchlassbereiches des Filters somit in den Durchlassbereich des Filters fallen können. Auf diese Weise wird z. B. erreicht, dass schon bei der Demodulation der Zwischenfrequenzsignale ZF der Frequenz-Phasen-Regelkreis des Synchrondemodulators in der Zwischenfrequenzstufe 4 länger eingerastet bleibt. Die der Zwischenfrequenzstufe 4 und damit der Demodulation nachfolgenden Filter können beispielsweise das Bildsignal FBAS so formen, dass nachfolgende signalverarbeitende Stufen wie beispielsweise der Farbdecoder 5 oder die Bilddatenkomprimierungsstufe 8 länger ihre Funktion aufrechterhalten können.

Die Auslegung der Filterkurven erfolgt in Abhängigkeit der Erfordernisse der nachgeschalteten Funktionsstufen, wobei vor allen auch subjektive Faktoren berücksichtigt werden. Z.B. wird es bei sehr schwachem Signal vom Betrachter oft als wenig störend empfunden, wenn nur die Schwarz-Weiß-Anteile des Bildes gezeigt werden. Vielmehr stören dagegen Synchronisationsverlust oder Standbild. Wie bereits erwähnt bewirkt eine Reduzierung von höherfrequenten Bildanteilen (Weichzeichnereffekt) bei schlechtem Empfangssignal ebenfalls einen angenehmeren Bildeindruck.

Der Verlauf der Übertragungsfunktion der selektiven Filterstufen ist abhängig vom jeweiligen Steuersignal bzw. den jeweiligen Steuersignalen. Bevorzugt werden die Filter so gesteuert, dass bei "gutem" Signal keine Beeinflussung des Nutzsignals erfolgt. Bei "schlechter" werdendem Signal adaptieren sich die Filterkurven stetig oder in Abstufungen und bewirken dadurch die oben erläuterten Systemverbesserungen.

Die Feldstärkeinformation kann darüber hinaus wie in Figur 1 angedeutet durch eine spezielle Einrichtung 9 gewonnen werden, die entweder vor der Kanalwählerstufe 2 oder nach der Kanalwählerstufe 2 ein Empfangssignal selektiert. Ebenfalls kann als Feldstärkeinformation eine Regelspannung in der Zwischenfrequenzstufe 4 dienen.

Weiterhin kann zumindest ein weiteres Steuersignal VS vorgesehen werden, die Feldstärkeinformationen mit zusätzlichen Informationen, insbesondere Bildgüteinformationen, aus nachgeschalteten insbesondere qualitätsbewertenden Stufen zu verknüpfen. Solche Informationen sind beispielsweise Synchronisationsverlust, Rauschanteil im Bild, Anstieg oder nicht ausreichende Bitrate. Diese Informationen können die selektiven Filterstufen 3, 6 in verschiedener Weise Beeinflussen wie beispielsweise in der Ansprechzeit oder ihrer Übertragungsfunktion.

## Patentansprüche

1. Fernsehempfänger mit einer Kanalwählerstufe (2), einer dieser nachgeschalteten selektiven Filterstufe (3) und einer dieser nachgeschalteten Zwischenfrequenzstufe (4), wobei eine Feldstärkedetektionsstufe (9, 4) vorgesehen ist, die ein der Feldstärke des Empfangssignals (HF) proportionales Feldstärkesignal erzeugt,
die selektive Filterstufe (3) eine Übertragungsfunktion aufweist, die mittels eines Steuersignals (CS, TS) veränderbar ist, und
das Steuersignal (CS) aus dem Feldstärkesignal hergeleitet ist, **dadurch gekennzeichnet, dass**
als die eine selektive Filterstufe (3) eine Frequenzfalle vorgesehen ist, deren Steilheit durch das Steuersignal (CS, VS, TS) veränderbar ist.

2. Fernsehempfänger nach Anspruch 1, **dadurch gekennzeichnet, dass** abhängig vom Steuersignal (CS, TS) die Bandbreite der selektiven Filterstufe (3) verändert wird.

3. Fernsehempfänger nach Anspruch 1 oder 2, **dadurch gekennzeichnet, dass** mindestens eine weitere selektive Filterstufe (6) der Zwischenfrequenzstufe (4) nachgeschaltet ist, die durch ein ebenfalls aus dem Feldstärkesignal hergeleitetes Steuersignal (CS, TS)gesteuert wird.

4. Fernsehempfänger nach Anspruch 3, **dadurch gekennzeichnet, dass**
im Empfangssignal ein Chrominanzsignal und ein Luminanzsignal enthalten ist und
die Frequenzfalle derart dimensioniert ist, dass bei grösserem Feldstärkesignal Spektralanteile des Chrominanzsignals stärker unterdrückt werden und bei geringerem Feldstärkesignal Rauschsignale im Spektralbereich von Luminanz- und Chrominanzsignal abgesenkt werden.

5. Fernsehempfänger nach einem der Ansprüche 1 bis 4, **dadurch gekennzeichnet, dass**
im Empfangssignal ein Schwarz-Weiss-Signal enthalten ist und bei niedrigem Feldstärkesignal nur Schwarz-Weiss-Signale durch das bzw. die selektiven Filterstufen (3, 6) durchgelassen werden.

6. Fernsehempfänger nach einem der Ansprüche 1 bis 5, **dadurch gekennzeichnet, dass**
im Empfangssignal ein Bildsignal (FBAS) enthalten ist und bei niedrigem Feldstärkesignal höherfrequente Bildsignale durch das bzw. die selektiven Filterstufen (3, 6) unterdrückt werden.

7. Fernsehempfänger nach einem der Ansprüche 1 bis 6, **dadurch gekennzeichnet, dass** das bzw. die selektiven Filterstufen (3, 6) so gesteuert werden, dass bei einem Feldstärkesignal über einem bestimmten Schwellenwert keine Signalbeeinflussung durch das bzw. die selektiven Filterstufen (3, 6) erfolgt.

8. Fernsehempfänger nach einem der Ansprüche 1 bis 7, **dadurch gekennzeichnet, dass** das bzw. die selektiven Filterstufen (3, 6) bei schwächer werdendem Feldstärkesignal stetig oder in Stufen das Filterverhalten adaptieren.

9. Fernsehempfänger nach einem der Ansprüche 1 bis 8, **dadurch gekennzeichnet, dass** die Feldstärkedetektionsstufe (9) das Empfangssignal (HF) auswertet und daraus das Feldstärkesignal erzeugt.

10. Fernsehempfänger nach einem der Ansprüche 1 bis 8, **dadurch gekennzeichnet, dass** als Feldstärkedetektionsstufe die Zwischenfrequenzstufe (4) vorgesehen ist, die daraus das Feldstärkesignal erzeugt.

11. Fernsehempfänger nach einem der Ansprüche 1 bis 10, **dadurch gekennzeichnet, dass**
der Zwischenfrequenzstufe (4) mindestens eine weitere Signalverarbeitungsstufe (8) nachgeschaltet ist und
das Steuersignal ausser aus dem Feldstärkesignal noch aus mindestens einem Signal der mindestens einen weiteren Signalverarbeitungsstufe (8) hergeleitet wird.

## Claims

1. Television receiver comprising a channel selector stage (2), a selective filter stage (3) connected downstream thereof and an intermediate frequency stage (4) connected downstream thereof, wherein a field strength detection stage (9, 4) is provided which generates a field strength signal proportional to the field strength of the received signal (HF), the selective filter stage (3) has a transfer function which can be changed by means of a control signal (CS, TS), and the control signal (CS) is derived from the field strength signal, **characterised in that** a frequency trap, the slope of which can be changed by the control signal (CS, VS, TS), is provided as the selective filter stage (3).

2. Television receiver as claimed in Claim 1, **characterised in that** the bandwidth of the selective filter stage (3) is changed as a function of the control signal (CS, TS).

3. Television receiver as claimed in Claim 1 or 2, **characterised in that** at least one further selective filter stage (6) is connected downstream of the intermediate frequency stage (4) and is controlled by a control signal (CS, TS) which is likewise derived from the field strength signal.

4. Television receiver as claimed in Claim 3, **characterised in that** one chrominance signal and one luminance signal are contained in the received signal, and the frequency trap is dimensioned in such a way that in the event of a higher field strength signal spectral components of the chrominance signal are more strongly suppressed and in the event of a lower field strength signal noise signals in the spectral range of the luminance and chrominance signal are reduced.

5. Television receiver as claimed in any one of Claims 1 to 4, **characterised in that** a black and white signal is contained in the received signal and in the event of a low field strength signal only black and white signals are transmitted by the selective filter stage or stages (3, 6).

6. Television receiver as claimed in any one of Claims 1 to 5, **characterised in that** a video signal (FBAS) is contained in the received signal, and that in the event of a low field strength signal higher-frequency video signals are suppressed by the selective filter stage or stages (3, 6).

7. Television receiver as claimed in any one of Claims 1 to 6, **characterised in that** the selective filter stage or stages (3, 6) is/are controlled in such a way that in the event of a field strength signal above a certain threshold value the selective filter stage or stages (3, 6) has/have no effect on the signal.

8. Television receiver as claimed in any one of Claims 1 to 7, **characterised in that** in the event of the field strength signal becoming weaker the selective filter stage or stages (3, 6) adapts/adapt the filter response continuously or in stages.

9. Television receiver as claimed in any one of Claims 1 to 8, **characterised in that** the field strength detection stage (9) evaluates the received signal (HF) and generates the field strength signal therefrom.

10. Television receiver as claimed in any one of Claims 1 to 8, **characterised in that** the intermediate frequency stage (4) is provided as field strength detection stage and generates the field strength signal therefrom.

11. Television receiver as claimed in any one of Claims 1 to 10, **characterised in that** at least one further signal processing stage (8) is connected downstream of the intermediate frequency stage (4) and the control signal is derived not only from the field strength signal but also from at least one signal from the at least one further signal processing stage (8).

## Revendications

1. Récepteur de télévision comportant un étage de sélection de canal (2), un étage de filtre sélectif monté à la suite de l'étage de sélection de canal et un étage de fréquence intermédiaire (4) monté à la suite de l'étage de filtre, un étage de détection d'intensité de champ (9, 4) est prévu, qui produit un signal d'intensité de champ proportionnel à l'intensité de champ du signal de réception (HF),
l'étage de filtre sélectif (3) comprenant une fonction de transmission, qui est modifiable au moyen d'un signal de commande (CS, TS), et
le signal de commande (CS) étant issu du signal d'intensité de champ, **caractérisé en ce que**
un piège à fréquence est prévu en tant qu'étage de filtre sélectif (3), dont la pente est modifiable par l'intermédiaire du signal de commande (CS, VS, TS).

2. Récepteur de télévision selon la revendication 1, caractérisé en ce la largueur de bande de l'étage de filtre sélectif (3) est modifiée en fonction du signal de commande (CS, TS).

3. Récepteur de télévision selon la revendication 1 ou 2, **caractérisé en ce qu'**au moins un autre étage de filtre sélectif (6) est monté à la suite de l'étage de fréquence intermédiaire (4), l'étage de filtre (6) étant commandé par un signal de commande (CS, TS) également issu du signal d'intensité de champ.

4. Récepteur de télévision selon la revendication 3, **caractérisé en ce qu'**un signal de chrominance et un signal de luminance sont contenus dans le signal de réception, et **en ce que** le piège à fréquence est dimensionné de telle sorte qu'avec un signal d'intensité de champ plus important, des composantes spectrales du signal de chrominance sont atténuées de manière plus importante et qu'avec un signal d'intensité de champ plus faible, des signaux de bruit sont réduits dans la zone spectrale des signaux de luminance et de chrominance.

5. Récepteur de télévision selon l'une des revendications 1 à 4, **caractérisé en ce que** un signal noir et blanc est contenu dans le signal de réception, et qu'avec un signal d'intensité de champ faible, uniquement les signaux noir et blanc passent à travers le ou les étage(s) de filtre sélectif (3, 6).

6. Récepteur de télévisions selon l'une des revendications 1 à 5, **caractérisé en ce qu'**un signal d'image FBAS est contenu dans le signal de réception et qu'avec un signal d'intensité de champ faible, des signaux d'image de fréquences supérieures sont atténués par le ou les étages de filtre sélectif (3, 6).

7. Récepteur de télévision selon l'une des revendications 1 à 6, **caractérisé en ce que** le ou les étages de filtre sélectif (3, 6) sont commandés de telle sorte qu'avec un signal d'intensité de champ excédant une valeur seuil déterminée, aucune influence sur le signal n'est produite à travers le ou les étages de filtre sélectif (3, 6).

8. Récepteur de télévision selon l'une des revendications 1 à 7, **caractérisé en ce que** le ou les étages de filtre sélectif (3, 6) avec un signal d'intensité de champ devenant plus faible, adapte en continu ou par palier le comportement du filtre.

9. Récepteur de télévision selon l'une des revendications 1 à 8, **caractérisé en ce que** l'étage de détection d'intensité de champ (9) évalue le signal de réception (HF) et en déduit le signal d'intensité de champ.

10. Récepteur de télévision selon l'une des revendications 1 à 8, **caractérisé en ce que** l'étage de fréquence intermédiaire (4) est prévu en tant qu'étage de détection d'intensité de champ, qui en déduit le signal d'intensité de champ.

11. Récepteur de télévision selon l'une des revendications 1 à 10, **caractérisé en ce que** au moins un autre étage de traitement de signal (8) est monté à la suite de l'étage de fréquence intermédiaire (4) et **en ce que** le signal de commande est obtenu, hormis à partir du signal d'intensité de champ, encore d'au moins un signal dudit au moins un autre étage de traitement de signal (8).
